# DEMANDE DE BREVET EUROPEEN

(11) **EP 2 639 640 A1**
(43) Date de publication de la demande: **18.09.2013**
(21) Numéro de dépôt: 13158772.7
(22) Date de dépôt: 12.03.2013
(51) Int. Cl.: G03F 7/20, H05K 3/00

(54) **Machine d'insolation de panneaux munie d'un retourneur de panneau**

(30) Priorité: 13.03.2012 FR 1252256
(71) Demandeur: Altix, 27100 Val de Reuil (FR)
(72) Inventeur: Cousin, Christophe, 27190 Orvaux (FR)
(74) Mandataire: Intès, Didier Gérard André

(57) **Abrégé**

Machine et procédé d'insolation de panneaux permettant de retourner un panneau et d'insoler successivement ses première et seconde faces.

Selon l'invention, cette machine comprend au moins un premier poste d'insolation (10), et un retourneur de panneau (30), ayant une première face et une deuxième face, ce dernier comprenant un dispositif de préhension (53, 54), configuré pour saisir un panneau (90), un dispositif de déplacement, configuré pour déplacer le dispositif de préhension au moins entre les premier et deuxième postes d'insolation (10, 20), et un dispositif de pivotement, configuré pour pivoter le dispositif de préhension (53, 54) et ainsi faire pivoter le panneau (90) autour d'un axe de pivotement (A) parallèle audit panneau (90), le retourneur (30) étant configuré de manière à pouvoir saisir le panneau (90) par l'une quelconque de ses faces et libérer le panneau (90) également par l'une quelconque de ses faces.

## Description

### DOMAINE DE L'INVENTION

Le présent exposé concerne une machine et un procédé d'insolation de panneaux, permettant de retourner un panneau et d'insoler successivement ses première et seconde faces.

Le domaine d'application de cette invention est principalement celui des circuits imprimés et des micro-processeurs mais l'invention peut également être utilisée dans tous les domaines utilisant des procédés de transfert d'image tel celui des écrans LCD ou celui de la fabrication de pièces de micromécanique par découpe chimique.

### ETAT DE LA TECHNIQUE ANTERIEURE

Parmi les nombreuses applications employant une insolation de panneaux, la plupart tirent parti des deux faces du panneau et requièrent donc une insolation de chacune de ses faces.

Pour réaliser une telle insolation recto-verso, une technique fréquemment utilisée est d'insoler la première face du panneau au sein d'un premier poste d'insolation muni d'un premier cliché, puis de transférer le panneau, après l'avoir retourné, vers un second poste d'insolation similaire au premier (généralement muni d'un cliché différent) pour insoler la deuxième face du panneau. Une telle technique apporte certains avantages spécifiques par rapport à d'autres techniques connues : par exemple, contrairement aux techniques d'insolation simultanée des deux faces, notamment, une telle insolation réalisée une face après l'autre ne souffre d'aucune ombre portée par certains éléments du dispositif et n'entraîne donc pas de zones non insolables sur le panneau.

Toutefois, cette technique « double simple face » nécessite une opération de retournement du panneau au moment de son transfert du premier poste d'insolation vers le second : or, une telle opération de retournement entraîne de nombreuses difficultés de conception. Ainsi, les solutions existantes souffrent d'un certain nombre de défauts.

On connait par exemple des dispositifs composés de trois machines actuatrices distinctes : une première, mobile selon deux axes, vient chercher le panneau sur le premier poste d'insolation puis se déplace jusqu'à une deuxième machine à qui elle transfère le panneau ; cette deuxième machine effectue le retournement ; puis une troisième machine analogue à la première récupère le panneau auprès de la deuxième machine et vient déposer le panneau retourné sur le deuxième poste d'insolation. Naturellement, on comprend qu'un tel dispositif composé de trois machines distinctes est très encombrant et génère un risque élevé de défaillance ainsi que des coûts d'investissement et de maintenance importants. En outre, le panneau est transféré de machine en machine avec, à chaque fois, un risque de dérèglement de la position attendue du panneau, pouvant nuire à la qualité du transfert d'image, et même un risque de chute et donc d'endommagement du panneau.

Il existe donc un réel besoin pour un dispositif et un procédé d'insolation de panneaux permettant de retourner et d'insoler un panneau successivement sur ses deux faces et qui soient dépourvus, au moins en partie, des inconvénients inhérents aux techniques connues précitées.

### PRESENTATION DE L'INVENTION

L'invention concerne une machine d'insolation de panneaux comprenant au moins un poste d'insolation comportant une embase configurée pour recevoir un panneau à plat, et un retourneur de panneau, ayant une première face et une deuxième face ; le retourneur de panneau comprend un dispositif de préhension, configuré pour saisir un panneau, un dispositif de déplacement, configuré pour pouvoir amener le dispositif de préhension en vis-à-vis de l'embase dudit au moins un poste d'insolation, et un dispositif de pivotement, configuré pour pivoter le dispositif de préhension et ainsi faire pivoter le panneau autour d'un axe de pivotement parallèle audit panneau, le retourneur étant configuré de manière à pouvoir saisir le panneau par l'une quelconque de ses faces et libérer le panneau également par l'une quelconque de ses faces.

Dans une telle machine d'insolation de panneaux, le retourneur de panneau déplace et dispose son dispositif de préhension au niveau d'un premier poste d'insolation, qui a réalisé l'insolation de la première face du panneau, ces derniers saisissent alors le panneau directement depuis le premier poste d'insolation ; le dispositif de déplacement du retourneur éloigne alors le dispositif de préhension, tenant le panneau, du premier poste d'insolation et le dispositif de pivotement pivote le dispositif de préhension de manière à pivoter solidairement le panneau et présenter sa seconde face ; le dispositif de déplacement amène alors le dispositif de préhension tenant le panneau au niveau d'un deuxième poste d'insolation, qui peut éventuellement être de nouveau le premier poste d'insolation ; le dispositif de préhension dispose alors le panneau retourné directement dans le deuxième poste d'insolation au sein duquel l'insolation de la deuxième face du panneau est réalisée.

Ceci est possible grâce au retourneur qui est capable de saisir le panneau par l'une quelconque de ses faces et de le libérer également par l'une quelconque de ses faces, c'est-à-dire par la même face ou par la face opposée à la face par laquelle le panneau a été saisi.

Ainsi, une seule machine est nécessaire pour réaliser le transfert et le retournement du panneau entre les premier et second postes d'insolation. Les fonctions de préhension, transfert et retournement du panneau sont ainsi mutualisées : une telle machine d'insolation de panneaux est donc fortement intégrée et facile à mettre en oeuvre. Particulièrement compacte, elle s'intègre facilement au sein d'une chaîne de fabrication. Elle est également particulièrement simple et donc plus économique tant en termes d'investissement que de maintenance. En outre, elle est remarquablement fiable. En effet, le panneau peut être saisi à plat et redéposé à plat directement sur les plans de travail des postes d'insolation, sans aucun autre transbordement intermédiaire : le bon positionnement du panneau est ainsi facilement préservé et les chutes sont évitées au moment des transbordements. Une telle machine est également particulièrement rapide puisque que seuls deux transbordements sont nécessaires et que le retournement peut s'effectuer concomitamment au déplacement vers le second poste d'insolation.

Dans certains modes de réalisation, la machine ne comprend qu'un seul poste d'insolation. Dans un tel cas, le retourneur saisit le panneau par sa première face au niveau de l'unique poste d'insolation qui a réalisé l'insolation de la première face du panneau ; le retourneur, tenant le panneau, s'éloigne alors du premier poste d'insolation et pivote solidairement avec le panneau de manière à présenter sa seconde face ; le retourneur revient alors au niveau de l'unique poste d'insolation et libère par sa seconde face le panneau retourné dans le poste d'insolation. Une telle configuration très compacte est particulièrement intéressante lorsque le même cliché doit être insolé sur les deux faces du panneau ou lorsque le cliché peut être modifié rapidement entre l'insolation de chaque face, notamment dans le cas d'un cliché numérique tel qu'utilisé dans les technologies de « direct imaging », c'est-à-dire d'imagerie directe.

Dans certains modes de réalisation, la machine comprend un premier poste d'insolation et un deuxième poste d'insolation, chaque poste d'insolation comportant une embase configurée pour recevoir le panneau à plat, et le dispositif de déplacement est configuré pour pouvoir amener le dispositif de préhension en vis-à-vis de l'embase de chaque poste d'insolation. Cette configuration est particulièrement intéressante lorsque des clichés différents doivent être insolés sur chaque face du panneau : il est possible en effet d'insoler des panneaux à la chaîne, un nouveau panneau à insoler arrivant dans le premier poste d'insolation tandis que le retourneur retourne et transporte le panneau insolé une première fois vers le deuxième poste d'insolation.

Dans certains modes de réalisation, le ou chaque poste d'insolation comporte une embase configurée pour recevoir le panneau à plat. Cette disposition à plat permet d'une part une fiabilité des transbordements avec le retourneur et une qualité accrue du transfert d'image lors de l'insolation, en raison notamment d'une orientation du panneau plus facile à maîtriser.

Dans certains modes de réalisation, ladite embase est munie d'un élévateur lui permettant de monter ou de descendre, le dispositif de déplacement étant configuré pour pouvoir amener le dispositif de préhension en vis-à-vis de l'embase du poste d'insolation. Cet élévateur permet de contrôler la position du panneau tant lors de l'insolation que lors du transbordement avec les moyens de préhension du retourneur pour assurer fiabilité et qualité. En outre, il permet de dégager l'espace nécessaire pour le passage du dispositif de préhension d'une part, mais également des autres éléments mobiles de la machine d'insolation d'autre part, et notamment le mobile de chargement de panneau permettant la mise en place du panneau sur l'embase du premier poste d'insolation. Enfin, grâce à cet élévateur, il est possible de limiter le déplacement du retourneur à une simple translation horizontale, ce qui simplifie sa conception.

Dans certains modes de réalisation, le ou chaque poste d'insolation comporte en outre une unité d'insolation, ou couvercle, munie d'un dispositif d'insolation et configurée pour porter un cliché, l'unité d'insolation du poste d'insolation étant fixe. Traditionnellement, c'est l'embase qui est fixe et l'unité d'insolation mobile pour plaquer le dispositif d'insolation et le cliché contre le panneau à insoler ; ici, l'inversion de ces caractéristiques permet de conserver cette exigence de proximité entre le panneau, le cliché et le dispositif d'insolation (l'embase vient plaquer le panneau contre l'unité d'insolation) et d'obtenir les avantages précités et notamment un contrôle permanent de la position du panneau sans que celui ne quitte l'embase et donc ne risque de chuter. En outre, cette configuration est aussi compacte, si ce n'est plus compacte, que la configuration avec une unité d'insolation mobile.

Dans certains modes de réalisation, le ou chaque poste d'insolation fonctionne selon une technologie de « direct imaging ». Dans un tel cas, l'unité d'insolation peut ne pas être configurée pour porter un cliché, le dispositif d'insolation étant alors configuré pour projeter directement le motif souhaité.

Dans certains modes de réalisation, l'embase et l'unité d'insolation d'un même poste d'insolation sont en vis-à-vis : dans un tel cas, l'embase est mobile selon le seul axe vertical.

Dans d'autres modes de réalisation, l'embase n'est pas en vis-à-vis de l'unité d'insolation portant les moyens d'insolations lorsque le panneau est retiré ou déposé. Dans un tel cas, l'embase peut être mobile sur au moins deux axes lui permettant de s'aligner avec l'unité d'insolation puis de se rapprocher de cette dernière. Dans d'autres cas, l'embase n'est mobile que selon l'axe vertical mais possède des moyens de chargement, un convoyeur à bande par exemple, lui permettant, une fois le panneau déposé, de le charger dans un espace d'insolation situé en vis-à-vis de l'unité d'insolation portant les moyens d'insolations.

Dans certains modes de réalisation, l'embase comprend des moyens de maintien du panneau maintenant fixement la position du panneau par rapport à l'embase ; ce maintien peut être réalisé par des éléments d'aspiration tels que des buses d'aspiration ou des ventouses commandées, qui maintiennent le panneau par succion. La fiabilité de l'insolation et du transbordement avec le retourneur s'en trouve accrue.

Dans certains modes de réalisation, le retourneur comprend un support et un cadre sensiblement rectangulaire coopérant avec le support par l'intermédiaire de deux tourillons disposés sur le cadre, ou sur le support, de manière coaxiale et de part et d'autre du cadre, définissant ainsi un axe de pivotement du cadre par rapport au support, ledit axe correspondant audit axe de pivotement du panneau. Le cadre comporte deux traverses longitudinales, de préférence parallèles à l'axe de pivotement, portant le dispositif de préhension. Le dispositif de pivotement, porté de préférence par le support, entraine au moins un desdits tourillons pour pivoter le cadre par rapport au support. Le dispositif de préhension est ainsi solidaire du cadre : lorsque le panneau est saisi par le dispositif de préhension, il est donc accueilli au sein du cadre et devient solidaire de ce dernier. Le cadre quant à lui est mobile en rotation par rapport au support et solidaire de ce dernier en translation. Les mouvements de translation et de pivotement du panneau sont ainsi avantageusement et simplement découplés. En outre, on vient ainsi saisir le panneau par ses bords : ces bordures étant des zones de garde non destinées à être insolées, le dispositif de préhension n'empiète donc pas sur la zone utile des panneaux dont on préserve ainsi la qualité de surface. De plus, cette configuration du dispositif de préhension permet de saisir des panneaux de tailles variables et même des panneaux très fins, d'épaisseur inférieure au mm notamment, qui risqueraient normalement de ployer s'ils n'étaient pas maintenus par leurs bords.

Dans certains modes de réalisation, le support coopère avec au moins un rail de la machine d'insolation le long duquel il est mobile et entraîné par le dispositif de déplacement. L'utilisation d'un rail permet une conception simple et une mise en oeuvre facilitée, notamment du dispositif de déplacement, en limitant l'entraînement à un seul degré de liberté.

Dans certains modes de réalisation, ledit rail est horizontal, le déplacement du support étant limité à un déplacement horizontal. On découple ainsi les mouvements horizontaux du panneau, assurés par le dispositif de déplacement du retourneur, de ses mouvements verticaux, assurés par l'élévateur de chaque poste d'insolation.

Dans certains modes de réalisation, les moyens de déplacement comprennent un moteur entraînant le déplacement du support le long dudit rail à l'aide d'un système à courroie.

Dans certains modes de réalisation, le support coopère avec un premier rail de la machine d'insolation le long duquel il est mobile et entraîné par le dispositif de déplacement et un deuxième rail de la machine d'insolation, opposé au premier rail, le long duquel il est librement mobile. Cette coopération avec ce deuxième rail peut se faire par l'intermédiaire de galets. De cette manière, le support, et donc le cadre, ne portent pas à faux. Ils sont ainsi stabilisés et conservent une inclinaison correcte.

Dans certains modes de réalisation, les moyens de préhensions comprennent, pour chaque traverse, une pluralité de ventouses commandées. Celles-ci peuvent être commandées individuellement ou par groupes pour maintenir l'aspiration, et donc tenir le panneau, ou interrompre l'aspiration et donc relâcher le panneau.

Dans certains modes de réalisation, chaque traverse comprend deux lames munies chacune d'un dispositif d'entraînement rotatif lui permettant de pivoter autour d'un axe parallèle à ladite traverse, et chaque lame est munie d'une pluralité de ventouses commandées reliées à une pompe à vide et agissant comme dispositif de préhension. Le dispositif d'entraînement rotatif permet de refermer les deux lames munies de ventouses de part et d'autre d'un bord du panneau pour le saisir en tenaille entre ces deux lames.

Dans certains modes de réalisation, le dispositif d'entraînement est de préférence un vérin rotatif.

Dans d'autres modes de réalisation, il s'agit d'un moteur.

Dans certains modes de réalisation, les lames d'une même traverse sont déportées par rapport à leurs axes de pivotement de telle sorte qu'elles peuvent s'étendre côte-à-côte dans un même plan ou en vis-à-vis, les ventouses de l'une étant alors dirigées vers les ventouses de l'autre. On parvient ainsi de manière compacte, simple et fiable à saisir en tenaille le bord du panneau ou laisser la place nécessaire au passage du panneau lors de son arrivée ou de son départ, et ceci des deux côtés du cadre.

Dans certains modes de réalisation, au moins une ventouse est munie d'un clapet automatique qui se ferme lorsqu'aucun objet n'est appliqué contre ladite ventouse. Ainsi, le retourneur s'adapte automatiquement à la longueur du panneau à insoler sans réglage particulier : si un panneau est plus petit et qu'une ventouse est située hors du champ occupé par le panneau, le clapet de cette dernière se ferme pour préserver la force d'aspiration des autres ventouses.

Dans certains modes de réalisation, au moins une ventouse est munie d'un ressort qui la repousse loin de la lame sur laquelle elle est montée. Il est ainsi possible d'adapter le retourneur, sans réglage particulier, à des panneaux d'épaisseurs différentes. On s'abstrait en outre des problèmes de jeux variables dus à un réglage imprécis de l'implantation des ventouses ou d'une mauvaise qualité de surface du panneau.

Dans d'autres modes de réalisation, au moins une ventouse est montée sur un vérin. Outre les avantages précités, on obtient également un degré de liberté supplémentaire au niveau des ventouses permettant un engagement et un désengagement de la préhension du panneau plus précis.

Dans certains modes de réalisation, les ventouses sont rondes. De préférence, elles possèdent un diamètre égal ou inférieur à 20mm.

Dans d'autres modes de réalisation, les ventouses sont ovales. De préférence, elles possèdent une largeur égale ou inférieure à 7mm. De cette manière, pour une force de succion égale, il est possible, en alignant les ventouses longitudinalement le long du bord du panneau, de réduire l'empiètement des ventouses sur la surface du panneau afin de préserver sa qualité de surface.

Dans certains modes de réalisation, chaque lame comporte huit ventouses disposées régulièrement le long de la lame. De préférence, l'implantation des ventouses est identique sur chaque lame.

Dans certains modes de réalisation, chaque traverse est montée entre deux chariots opposés, chaque chariot étant mobile et entrainé le long d'un montant du cadre. De cette manière, il est possible d'adapter facilement le retourneur à différente largeurs de panneaux. Cette réalisation peut se faire automatiquement sur la simple donnée de la taille du panneau ou après détection de la taille du panneau par des capteurs.

Dans certains modes de réalisation, chaque chariot coopère avec un rail de guidage disposé le long dudit montant du cadre. De préférence, ce rail de guidage est une barre.

Dans certains modes de réalisation, une vis d'Archimède est disposée le long d'au moins un desdits montants. De préférence, une vis d'Archimède est disposée le long de chaque montant le long duquel s'étend un rail de guidage.

Dans certains modes de réalisation, certains chariots comportent un moteur engrenant sur ladite vis d'Archimède pour assurer leurs déplacements le long desdits montants. En particulier, chaque chariot peut comporter un tel moteur. De préférence, ce moteur est du type pas-à-pas pour assurer la précision du positionnement du chariot.

Dans d'autres modes de réalisation, la vis d'Archimède peut être entraînée en rotation par un moteur pas-à-pas fixé au cadre et le chariot peut progresser le long de cette vis grâce à un écrou engrenant sur ladite vis.

Dans certains modes de réalisation, chaque chariot comporte le vérin rotatif d'une première lame de la traverse et un palier supportant la deuxième lame de la même traverse. Cette configuration est plus compacte et s'intègre mieux dans le cadre.

Dans certains modes de réalisation, le dispositif de pivotement comprend un moteur, monté sur le support, qui entraîne, un des tourillons du cadre pour pivoter le cadre dans une plage d'inclinaison d'au moins 180° d'amplitude.

Dans certains modes de réalisation, et de manière compacte, ledit moteur entraîne ledit tourillon par l'intermédiaire d'un réducteur à renvoi d'angle.

Dans d'autres modes de réalisation, il peut l'entrainer par l'intermédiaire d'une courroie de transmission.

Dans certains modes de réalisation, les tourillons sont disposés sur le cadre de telle manière que l'axe de pivotement du cadre soit une médiane dudit cadre. Le volume balayé par le cadre lors de son pivotement est ainsi réduit.

Dans certains modes de réalisation, l'axe de pivotement du cadre est horizontal et ladite plage d'inclinaison inclut au moins les deux positions horizontales, l'une dirigée vers le haut, l'autre dirigée vers le bas.

Le présent exposé concerne également un procédé d'insolation de panneaux utilisant une machine d'insolation selon l'un quelconque des modes de réalisation décrits ci-dessus.

Les caractéristiques et avantages précités, ainsi que d'autres, apparaîtront à la lecture de la description détaillée qui suit, d'un exemple de réalisation du dispositif et du procédé proposé. Cette description détaillée fait référence aux dessins annexés.

### BREVE DESCRIPTION DES DESSINS

Les dessins annexés sont schématiques et visent avant tout à illustrer les principes de l'invention.

Sur ces dessins, d'une figure (FIG) à l'autre, des éléments (ou parties d'élément) identiques sont repérés par les mêmes signes de référence.
La FIG 1A est une représentation d'ensemble schématique d'un exemple de machine d'exposition vu de face.
La FIG 1B est une représentation d'ensemble schématique de l'exemple de machine d'exposition de la FIG 1A vu de dessus.
La FIG 2 est une vue en perspective d'un exemple de retourneur selon l'invention.
La FIG 3 est un agrandissement d'une partie de cet exemple de retourneur correspondant au cadre III de la FIG 2.
La FIG 4 est une vue en perspective d'une autre partie du retourneur selon la flèche IV de la FIG 3.
Les FIG 5A à 5G sont des représentations schématiques de différentes phases du procédé mettant en oeuvre la machine de la FIG 1A.

### DESCRIPTION DETAILLEE D'UN EXEMPLE DE REALISATION

Afin de rendre plus concrète l'invention, un exemple de dispositif et de procédé est décrit en détail ci-après, en référence aux dessins annexés. Il est rappelé que l'invention ne se limite pas à cet exemple.

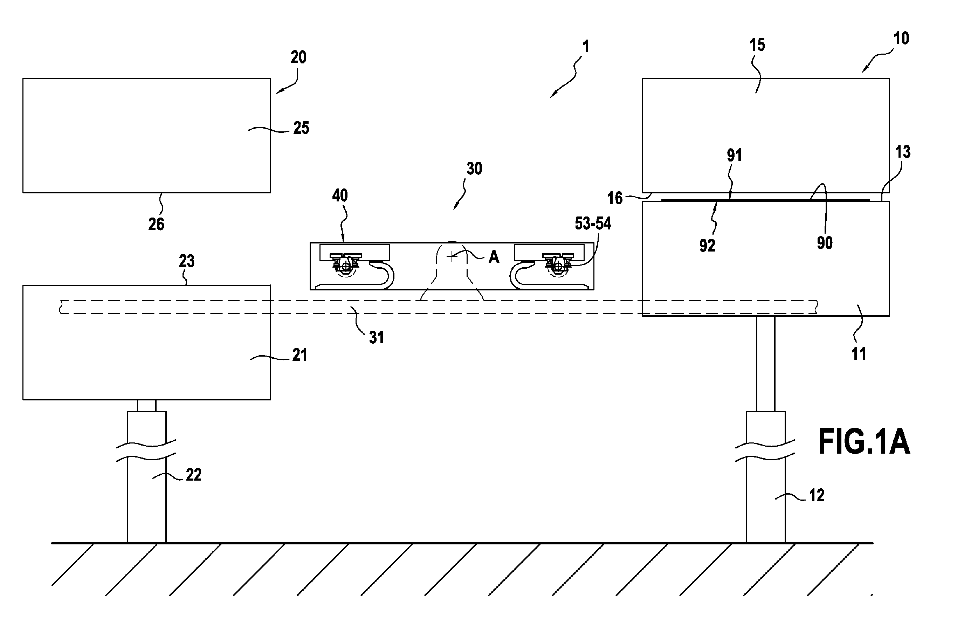

Dans la présente description détaillée, les indications de direction ou de position (haut, bas, droite, gauche, avant, arrière, intérieur, extérieure etc.) sont définies par rapport au cadre 40 dans son état non retourné vu de face tel qu'il est représenté sur la FIG 1A. En outre, lorsque l'on parle de la direction d'une ventouse 53, 54, on entend parler de la direction vers laquelle pointe la tête de la ventouse 55.

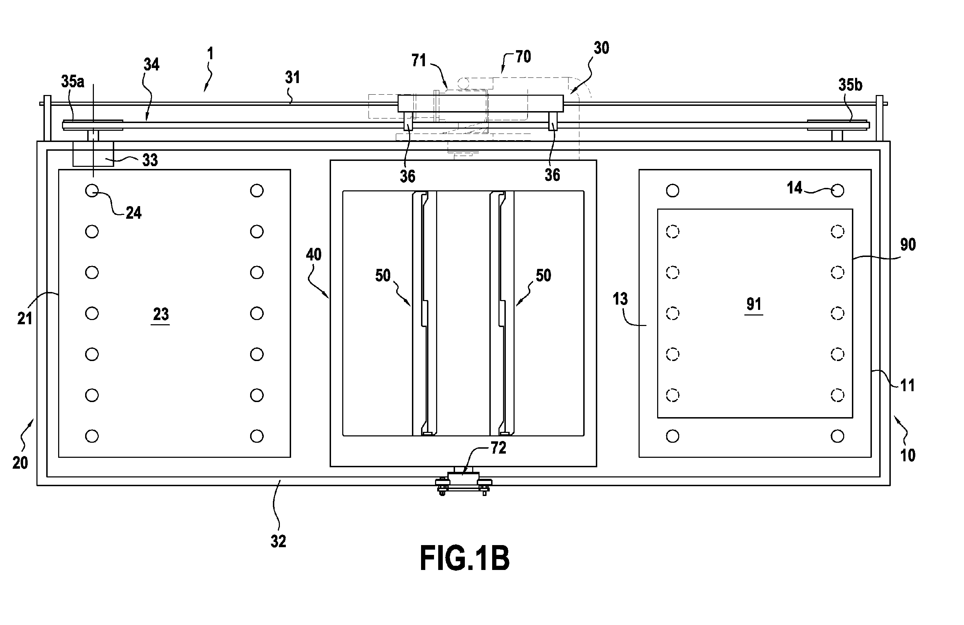

Les FIG 1A et 1B représentent schématiquement l'ensemble des organes d'un exemple de réalisation d'une machine d'exposition 1 selon l'invention vue en élévation et de dessus respectivement.

La machine 1 comprend un premier poste d'insolation 10, un deuxième poste d'insolation 20, analogue au premier 10, un mobile de chargement de panneau (non représenté), un mobile de déchargement de panneau (non représenté) et un retourneur 30.

Chaque poste d'insolation 10, 20 comprend une embase 11, 21 et une unité d'insolation 15, 25. Chaque embase 11, 21 présente à son extrémité supérieure une table de travail 13, 23 plane et horizontale destinée à recevoir un panneau 90 à insoler ; les tables de travail 13 et 23 sont équipées à leurs surfaces de buses d'aspiration 14, 24 permettant de maintenir, par succion, le panneau 90 en position sur la table de travail 13, 23. Chaque embase 11, 21 est en outre munie d'un élévateur 12, 22 lui permettant de régler le niveau, c'est-à-dire l'altitude, de la table de travail 13, 23. Chaque unité d'insolation 15, 25 est munie de moyens d'insolations composés de diodes électroluminescentes UV et présente à son extrémité inférieure une vitre d'exposition 16, 26 derrière laquelle un cliché représentant le négatif d'un motif à projeter et à reproduire sur le panneau 90 peut être adapté. Le premier poste d'insolation 10 est destiné à insoler la face recto 91 du panneau 90 tandis que le deuxième poste d'insolation 20 est destiné à insoler la face verso 92 du panneau 90.

Le mobile de chargement de panneau permet d'aller chercher un panneau 90 dans une section amont d'une chaîne de production de composants électroniques et de le déposer sur la table de travail 13 du premier poste d'insolation 10. Le mobile de déchargement de panneau permet de venir chercher un panneau 90 sur la table de travail 23 du deuxième poste d'insolation 20 et de l'apporter à une section aval de la chaîne de production.

Le retourneur 30 comprend un cadre 40 monté en rotation sur un support 70, composé d'une première partie de support 71 et d'une deuxième partie de support 72 opposée à la première partie 71 par rapport au cadre 40. Le support 70 est lui-même monté en translation sur des rails horizontaux 31, 32 fixés au bâti de la machine 1, la première partie de support 71 coopérant avec un premier rail horizontal 31, arrière, et la deuxième partie de support 72 coopérant avec un deuxième rail horizontal 32, avant, fixé en vis-à-vis du premier rail 31. Le retourneur 30 comprend en outre un dispositif de déplacement fixé au bâti de la machine 1 entraînant la première partie de support 71 en translation le long du premier rail 31. Dans cet exemple de réalisation, le dispositif de déplacement comprend un moteur 33 muni d'un système d'entrainement à courroie 34. Dans cet exemple, une courroie 34 court entre une première poulie 35a fixée à l'axe d'un moteur 33 fixé à une première extrémité du bâti et une deuxième poulie 35b fixée à une seconde extrémité du bâti ; la première partie de support 71 est attachée en un ou plusieurs points de fixation 36 de la courroie 34. Ainsi, la mise en rotation du moteur 33 permet l'entraînement de la courroie 34 et donc du support 70 le long des rails 31 et 32.

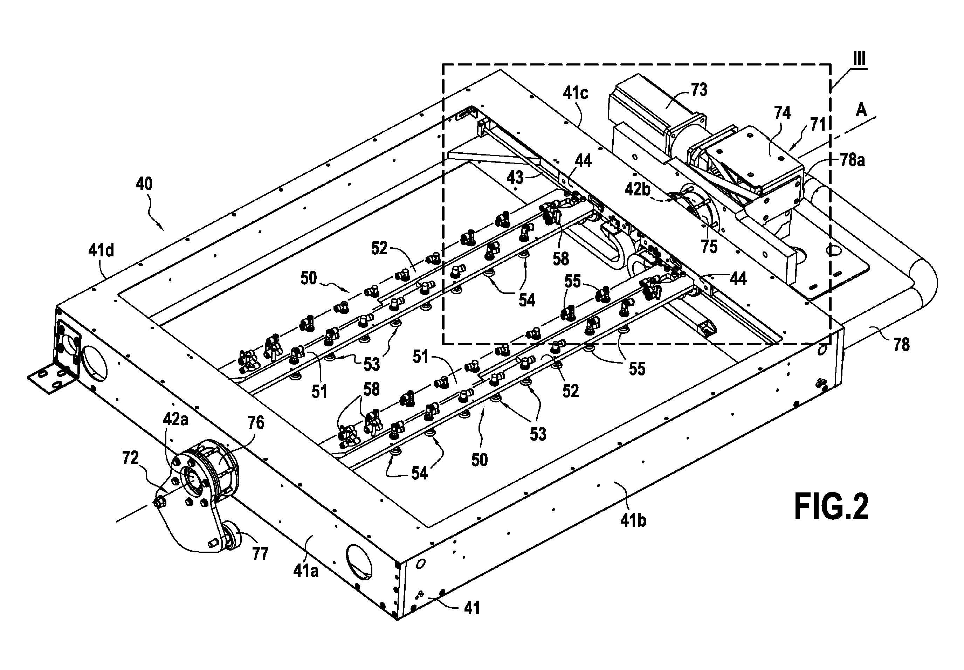

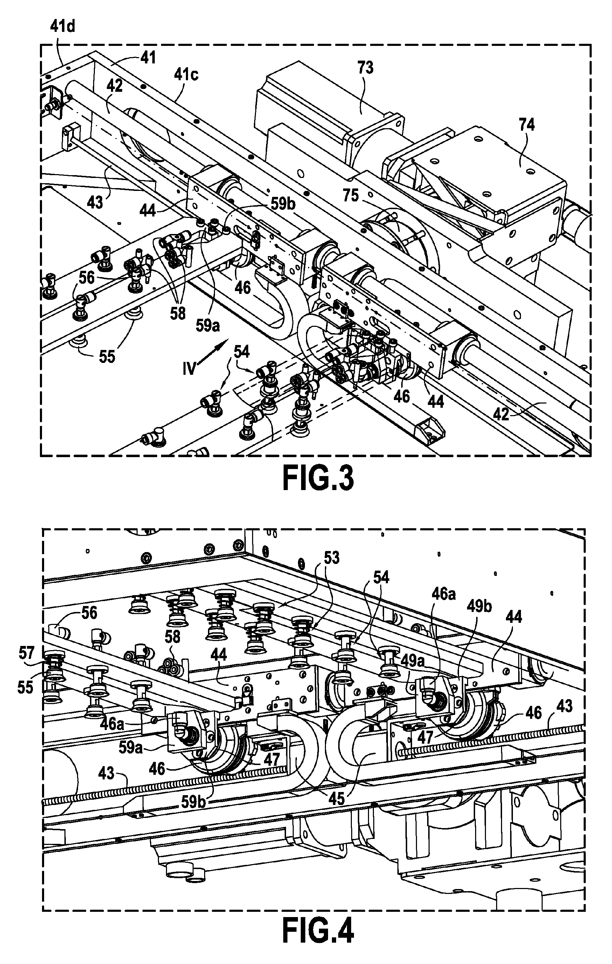

Les FIG 2, 3 et 4 représentent sous différents angles le cadre 40 et le support 70 du retourneur 30. Plus particulièrement, la FIG 3 est un agrandissement du cadre III de la FIG 2 et la FIG 4 est une vue selon la direction IV de la FIG 3.

Le cadre 40 comprend quatre montants, respectivement avant 41a, droit 41b, arrière 41c et gauche 41d, formant un châssis rectangulaire 41. Les montants avant 41a et arrière 41c présentent respectivement, au milieu de leurs faces extérieures, un tourillon avant 42a et un tourillon arrière 42b (masqué sur les figures) permettant au cadre 40 de coopérer avec le support 70. Ces deux tourillons 42a, 42b, coaxiaux, définissent ainsi un axe de pivotement A du cadre 40 par rapport au support 70 ; cet axe de pivotement A est ainsi parallèle aux montants droit 41b et gauche 41d du cadre 40.

Le cadre 40 comprend en outre une barre de guidage 42 fixée au châssis 41 le long de son montant arrière 41c et s'étendant ainsi parallèlement au plan d'ensemble du cadre 40 d'une part et au montant arrière 41c d'autre part. La cadre 40 comprend également, le long du même montant arrière 41c, une vis d'Archimède 43 fixée au châssis et s'étendant parallèlement à ladite barre de guidage 42. Dans cet exemple de réalisation, la barre de guidage 42 est disposée à proximité du bord supérieur du montant arrière 41c tandis que la vis d'Archimède 43 est disposée à proximité du bord inférieur du montant arrière 41c. Une deuxième barre de guidage 42 et une deuxième vis d'Archimède 43 sont également disposées, de manière parfaitement analogue, le long du montant avant 41a du châssis 41.

Autour de chaque barre de guidage 42, sont disposés deux chariots 44 montés en coulissement le long de la barre de guidage 42. Certains chariots 44 sont munis d'un moteur pas-à-pas 45 qui engrène sur la vis d'Archimède 43 afin d'entraîner ces chariots 44 le long du montant avant 41a ou arrière 41c.

Chaque chariot 44 disposé le long du montant arrière 41c est associé avec un chariot 44 disposé le long du montant avant 41a, ces deux chariots 44 associés étant reliés par une traverse 50 globalement parallèle à l'axe de pivotement A. Ainsi, dans cet exemple de réalisation, un chariot 44 dans chaque couple de chariots 44 ainsi associés est dépourvu de moteur pas-à-pas 45, son déplacement étant alors solidaire de l'autre chariot de son couple grâce à la jonction rigide offerte par cette traverse 50. Dans d'autres exemples de réalisation, chaque chariot 44 possède son propre moteur pas-à-pas 45 : les moteurs pas-à-pas 45 des deux chariots 44 d'un même couple sont alors activés simultanément pour permettre le déplacement synchronisé de ces chariots 44.

Chaque traverse 50 comprend une lame intérieure 51 et une lame extérieure 52 prenant chacune la forme d'une plaque fine et allongée, à l'allure de règle, parallèle à l'axe de pivotement A. La première extrémité de chacune de ces lames 51, 52 est fixée à un premier chariot 44 tandis que sa deuxième extrémité est fixée au chariot 44 associé audit premier chariot 44.

Chaque lame, intérieure 51 ou extérieure 52, est munie d'une pluralité de ventouses 53, 54. Chaque ventouse 53, 54 est composée d'une tête de ventouse 55, destinée à être appliquée contre le panneau 90 et dirigée vers le plan médian du cadre 40, et un embout 56 permettant la connexion de la ventouse 53, 54 à une pompe à vide par l'intermédiaire d'un tuyau flexible. Des ventouses 53, 54 sont munies en outre de ressorts 57 respectifs repoussant la tête de ventouse 55 loin de la lame 51, 52 sur laquelle elles sont montées et permettant de s'adapter à des épaisseurs différentes de panneaux 90 et de compenser certains défauts de surface du panneau 90 ou certains jeux dans le montage du cadre 40. De plus, certaines ventouses 54 sont munies de clapets automatiques respectifs qui coupent automatiquement l'aspiration lorsqu'aucun objet, et notamment le panneau 90, n'est appliqué contre de telles ventouses 54 afin de préserver la force d'aspiration des autres ventouses 53, 54. D'autres ventouses 53, disposées au centre des lames 51, 52, sont dépourvues de clapet car, quelle que soit la taille du panneau 90, celui-ci est toujours appliqué contre ces ventouses dépourvues de clapet 53.

Dans cet exemple de réalisation, chaque lame 51, 52 possède huit ventouses 53, 54 réparties régulièrement, à intervalle fixe, tout le long de la lame 51, 52. Parmi ces ventouses, les quatre ventouses centrales sont des ventouses dépourvues de clapet 53 tandis que les deux groupes de deux ventouses encadrant ces ventouses dépourvues de clapet 53 sont des ventouses pourvues de clapet 54.

Chaque lame 51, 52 est munie en outre de raccords 58 disposés en bout de lame permettant diviser un tuyau en provenance de la pompe à vide en une pluralité de tuyaux, chacun connecté à l'embout 56 d'une ventouse 53, 54 donnée. Les ventouses 53, 54 sont ainsi commandées lame par lame 51, 52. Afin de ne pas encombrer inutilement les figures, ces réseaux de tuyaux n'ont été représentés.

Chaque lame 51, 52 est montée entre un vérin pneumatique rotatif 46 d'une part, prévu sur son premier chariot 44, et un palier 47 d'autre part, prévu sur son deuxième chariot 44. Ainsi, chaque lame 51 et 52 peut être entraînée en rotation par son vérin rotatif 46 autour d'une axe de vérin V parallèle à l'axe de pivotement A.

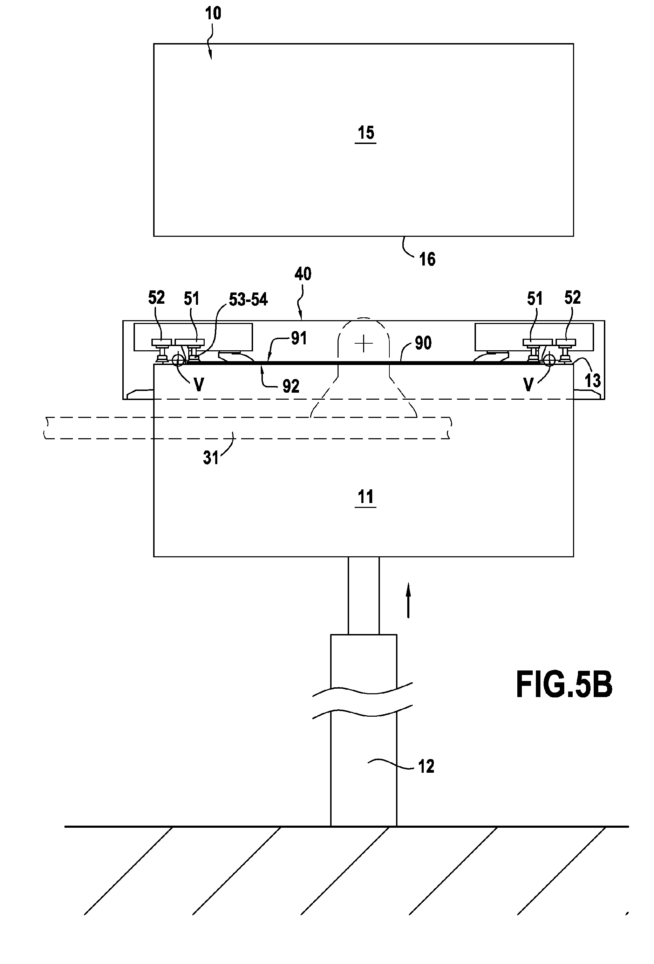

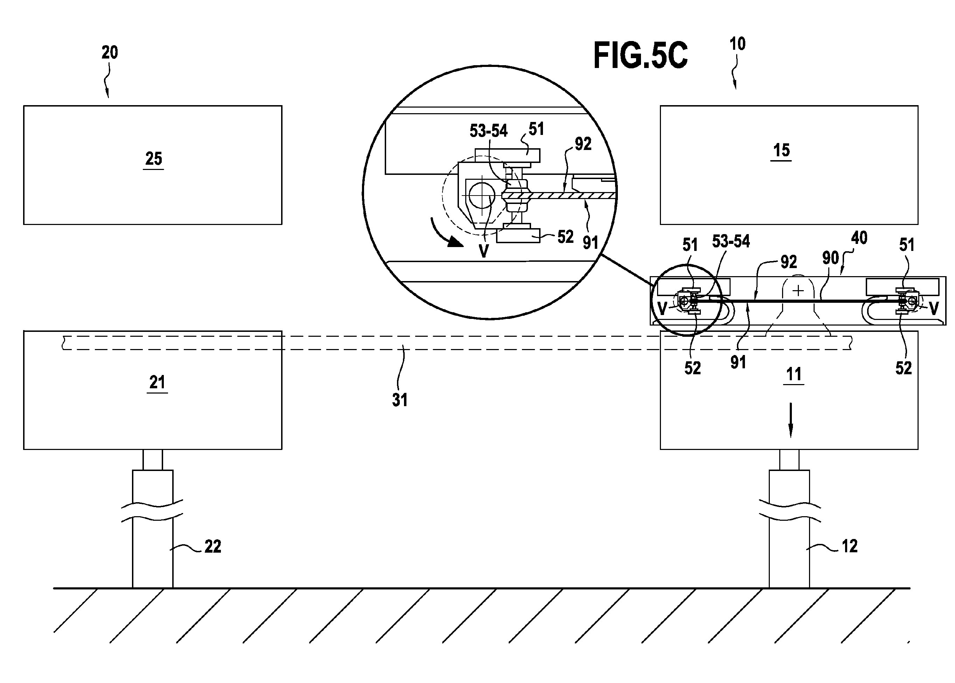

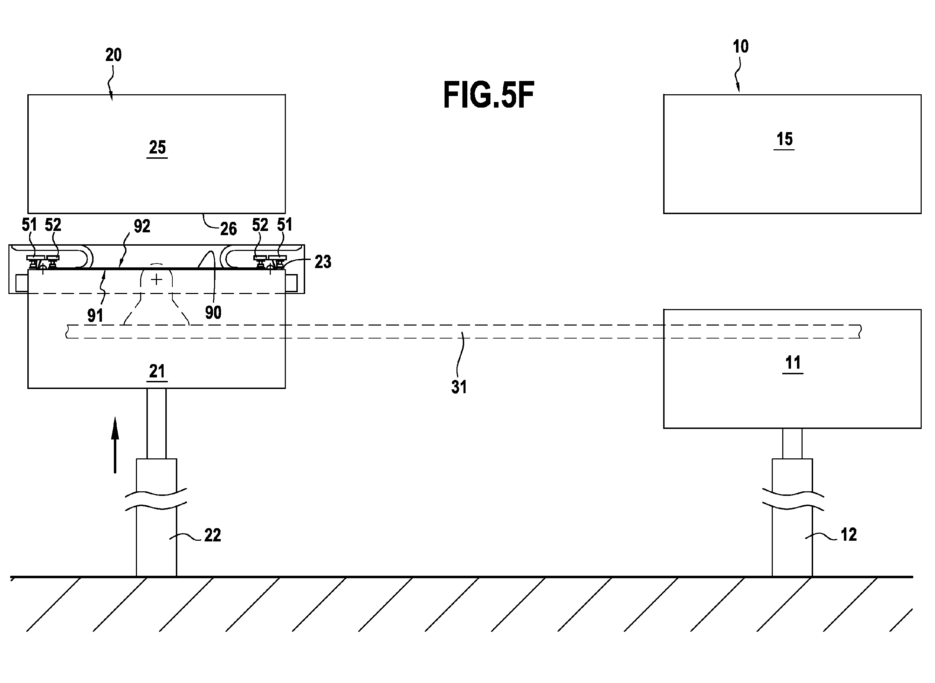

En particulier, les lames 51, 52 sont montées sur leurs vérins 46 et leurs paliers 47 respectifs par l'intermédiaire de pattes de déport 59a et 59b de telle manière que les lames 51 et 52 de chaque traverse 50 peuvent s'étendre l'une à côté de l'autre, leurs ventouses 53, 54 respectives dirigées vers la bas du cadre 40 (voir FIG 5B), l'une en face de l'autre, leurs ventouses 53, 54 respectives dirigées en vis-à-vis (voir FIG 5C), ou l'une à côté de l'autre, leurs ventouses 53, 54 respectives dirigées vers le haut du cadre (voir FIG 5F sur laquelle le haut de cadre est dirigé vers le bas de la figure, ledit cadre ayant été retourné).

Dans cet exemple de réalisation, chaque chariot 44 possède ainsi un vérin 46 pour une première lame 51, 52 de sa traverse 50 et un palier 47, concentrique à l'axe V du vérin rotatif 46, pour la deuxième lame 51, 52 de sa traverse 50. Chaque vérin rotatif 46 est muni d'un embout 46a permettant sa connexion à un circuit pneumatique de commande (non représenté à des fins de simplification des figures).

L'ensemble des ventouses 53, 54 constituent ainsi des moyens de préhension du panneau 90 à double titre. D'une part, les ventouses 53, 54 permettent de saisir et de maintenir le panneau 90 par aspiration. D'autre part, lorsque les lames 51 et 52 sont refermées l'une en face de l'autre, à la manière d'une mâchoire, le panneau 90 est pris en tenaille entre les ventouses 53, 54 d'une première lame 51 ou 52 et celles de la deuxième lame 51 ou 52 ce qui assure une bonne préhension du panneau 90.

Il faut noter en outre, que le cadre 40 peut s'adapter rapidement et facilement à différentes tailles de panneaux 90. En effet, l'adaptation en largeur s'effectue en réglant l'écartement des traverses 50, c'est-à-dire en déplaçant les chariots le long des barres de guidage 42 à l'aide des moteurs pas-à-pas 45. Ce réglage peut être réalisé automatiquement en entrant simplement la taille du panneau 90 dans le logiciel de contrôle de la machine 1. Quant à l'adaptation en longueur, celle-ci s'effectue automatiquement et sans aucun réglage grâce aux ventouses pourvues de clapets 54 : les ventouses 54 disposées hors du champ du panneau 90 sont en effet automatiquement désactivées ce qui préserve l'efficacité de préhension des autres ventouses 53 ou 54.

Si l'on s'intéresse maintenant au support 70, sa première partie 71 comprend un moteur de pivotement 73 qui, au travers d'un réducteur à renvoi d'angle 74, entraîne le tourillon arrière 42b du cadre 40 pour pivoter le cadre 40 autour de l'axe de pivotement A. Un palier arrière 75 supporte en outre la rotation du tourillon arrière 42b. Dans cet exemple de réalisation, un réducteur à renvoi d'angle 74 est utilisé pour permettre une configuration compacte dans laquelle le moteur 73 est disposé dans le plan d'ensemble du cadre 40 et le long du montant arrière 41c de ce dernier.

La première partie 71 du support 70 comporte en outre des moyens de coopération avec le rail horizontal arrière 31 et la courroie 34 du dispositif de déplacement qui ne sont pas représentés sur les vues de détail des FIG 2, 3 et 4.

La deuxième partie 72 du support 70 comporte quant à elle un palier avant 76 supportant et autorisant la libre rotation du tourillon avant 42a du cadre 40. La deuxième partie 72 du support 70 comporte en outre des galets 77 lui permettant de se déplacer librement le long du rail horizontal avant 32 de la machine 1.

Afin de permettre le passage de l'ensemble des alimentations électriques, pneumatiques et de vide depuis le support 70 jusqu'au cadre 30, un tube coudé 78 est prévu à une extrémité latérale du montant arrière 41c du cadre 40 : celui-ci est coudé de manière à se diriger vers la première partie 71 du support 70, en arrière du moteur de pivotement 73 et au voisinage de l'axe de pivotement A. Un tronçon flexible 78a permet alors de connecter le support 70 à ce tube coudé 78 et de suivre ce dernier lors de son pivotement autour de l'axe de pivotement A.

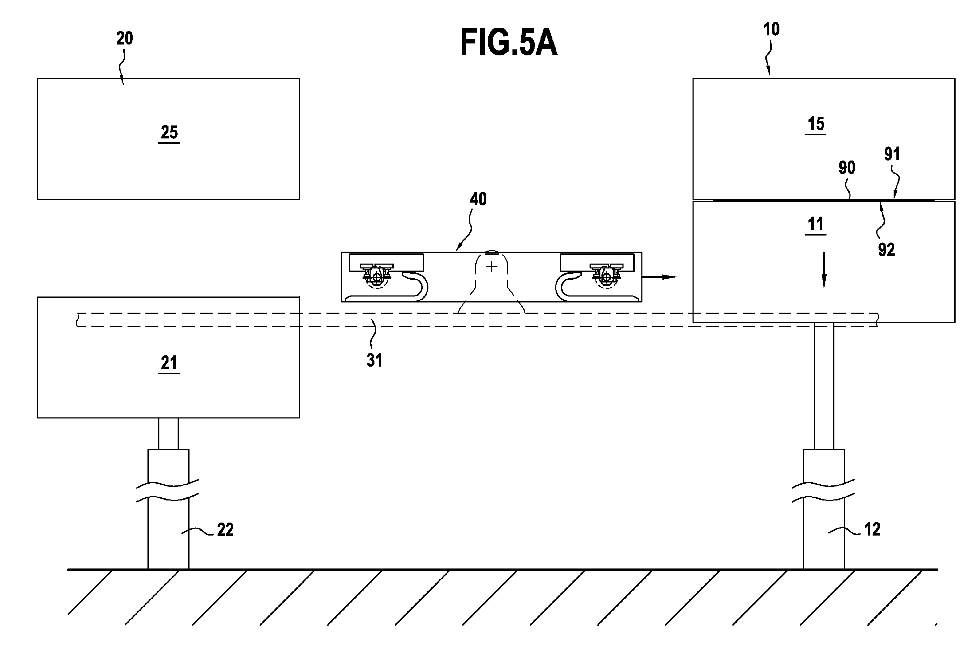

Un exemple de procédé d'insolation de panneau mettant en oeuvre la machine d'insolation 1 ainsi décrite va maintenant être expliqué en référence aux FIG 5A à 5G.

L'état initial de ce procédé est un état dans lequel le mobile de chargement de panneau vient de déposer un panneau 90 sur la table de travail 13 de l'embase 11 du premier poste d'insolation 10. Une fois le panneau 90 déposé en position, les buses d'aspirations 14 s'activent pour maintenir la position du panneau 90. L'élévateur 12 élève alors l'embase 12 de manière à plaquer la table de travail 13 et le panneau 90 contre la vitre d'exposition 16 de l'unité d'insolation 15 du premier poste d'insolation 10 : cette étape est représentée en FIG 5A. Dans cette position de forte proximité, les moyens d'insolation de l'unité d'insolation insolent la face recto 91 du panneau 90 à travers le cliché disposé derrière la vitre d'exposition 16 : le négatif du cliché est ainsi impressionné sur la face recto 91 du panneau 90.

L'insolation de cette face recto 91 terminée, l'embase 13 redescend, grâce à l'élévateur 11, jusqu'à un niveau permettant le passage du cadre 40 entre l'embase 13 et l'unité d'insolation 15. Lorsque le passage est suffisant, le cadre 30 est déplacé par le dispositif de déplacement en vis-à-vis de l'embase 13 : celle-ci remonte alors jusqu'à plaquer le panneau 90 contre les ventouses 53, 54 des lames intérieures 51 des traverses 50. Le réglage de la position des chariots 44 a été effectué de manière à ce que les ventouses 53, 54 des lames intérieures 51 s'appliquent au plus près du bord latéral du panneau 90 et à ce que, en tout état de cause, les axes des vérins V s'etendent à l'extérieur du panneau 90. En conséquence, à ce stade, les ventouses 53, 54 des lames extérieures pointent dans le vide. Cette étape est représentée sur la FIG 5B. A ce stade, on coupe l'aspiration des buses d'aspiration 14 de l'embase 13 et on crée le vide dans les ventouses 53, 54 des lames intérieures 51 de manière à ce que le panneau 90 adhère à ces dernières.

L'embase 13 redescend alors pour permettre aux lames extérieures 52 de se rabattre sur la face inférieure, c'est-à-dire la face verso 92, du panneau 90. Cet étape est représenté en FIG 5C. Le panneau 90 se retrouve ainsi pris en tenaille entre les ventouses 53, 54 des lames intérieures 51 et extérieures 52 du cadre 40. On crée le vide dans les ventouses 53, 54 des lames extérieures 52.

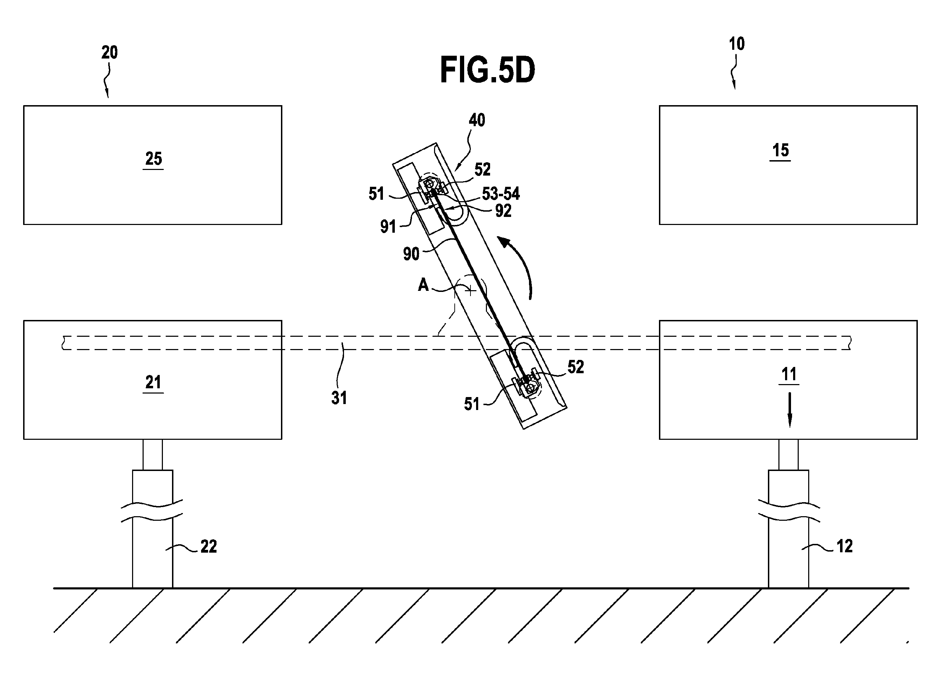

Le panneau 90 désormais fermement saisi par les lames 51, 52 du cadre 40, le cadre se déplace horizontalement jusqu'à une position sensiblement à mi-chemin entre les deux postes d'insolation 10 et 20. Arrivé dans cette position médiane, le moteur de pivotement 73 retourne le cadre 40 de 180° qui se retrouve ainsi tête en bas. Cette étape de retournement est représentée en FIG 5D. Dans certains exemples de réalisation, le déplacement horizontal depuis le premier poste d'insolation 10 vers le deuxième poste d'insolation 20 et le retournement du cadre 40 ont lieu simultanément.

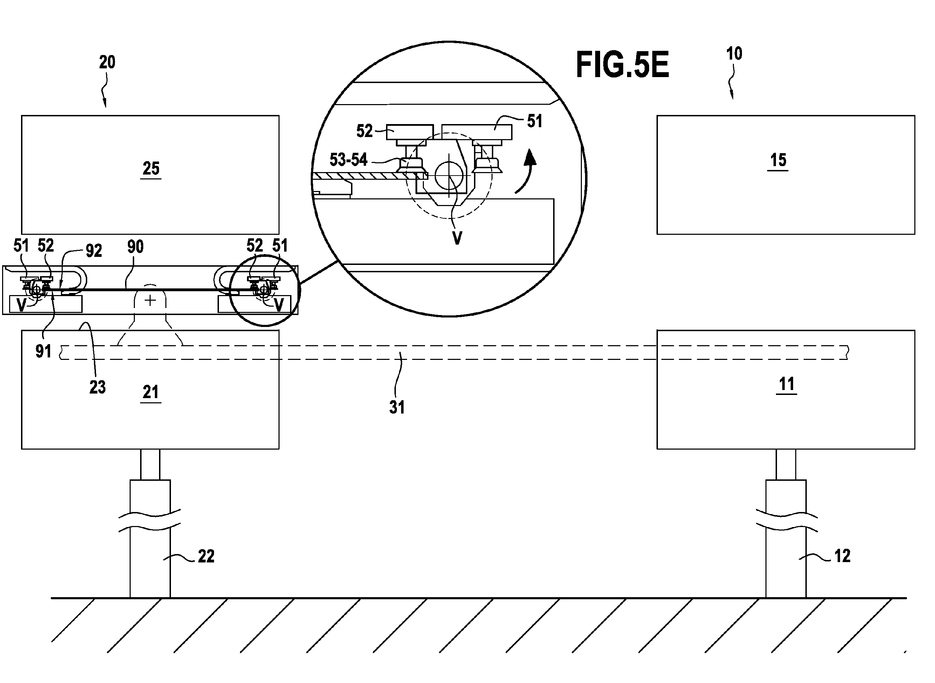

A l'arrivée du cadre 40 au niveau du deuxième poste d'insolation 20, l'embase 21 du deuxième poste 20 est abaissée pour laisser le passage nécessaire au cadre 40. Comme cela est représenté en FIG 5E, une fois le cadre 40 en vis-à-vis de l'embase 20, l'aspiration est coupée dans les ventouses 53, 54 des lames intérieures et les lames intérieures 51 se rabattent à leur tour vers le bas du cadre (c'est-à-dire vers le haut sur la FIG 5E, le cadre ayant été retourné), ouvrant ainsi les mâchoires constituées par les ventouses 53, 54 des lames intérieures 51 et extérieures 52. On peut noter à ce sujet que les lames intérieures 51 se retrouvent désormais à l'extérieur des lames extérieures 52 par rapport au centre du cadre 40.

Le panneau 90 est alors simplement maintenu par l'aspiration des ventouses 53, 54 des lames extérieures 52 (désormais à l'intérieur) tandis que l'embase 22 est élevée jusqu'au contact avec le panneau 90. Dès lors, le vide est rompu dans les ventouses 53, 54 des lames extérieures et le panneau 90 se retrouve donc directement en position sur la table de travail 23 de l'embase 22 sans avoir subi aucun à-coup. On enclenche alors les buses d'aspiration 24 de l'embase pour maintenir le panneau 90 en position sur la table de travail 23. Cet étape est représentée en FIG 5F. On note à cette occasion que la face du panneau 90 exposée face à l'unité d'insolation 25 du deuxième poste d'insolation 20 est désormais la face verso 92.

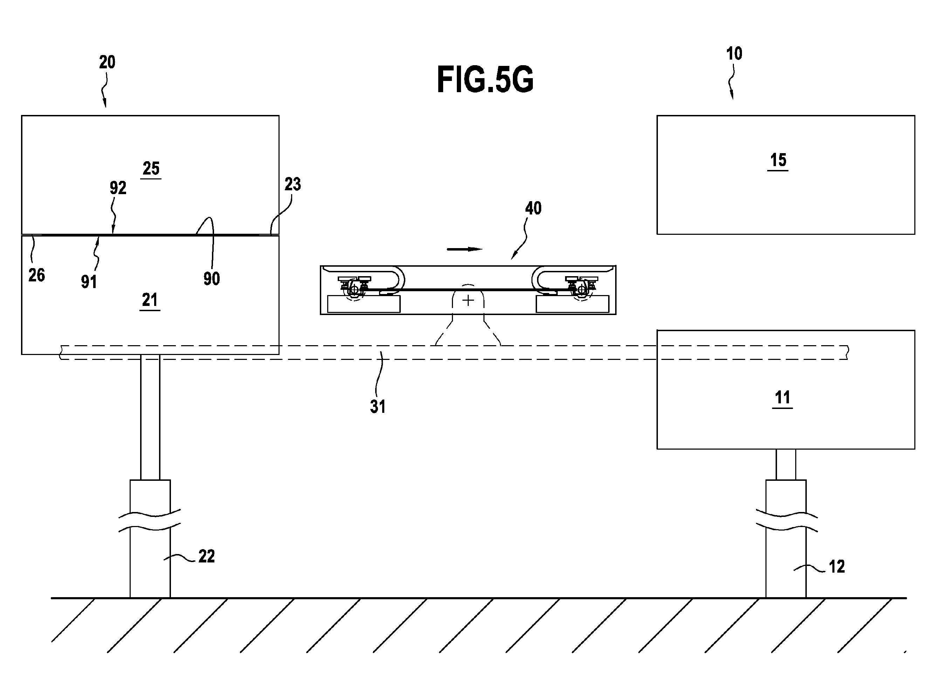

L'embase 21 redescend alors suffisamment pour laisser repartir le cadre 40 puis remonte jusqu'à plaquer la table de travail 23 et le panneau 90 contre la vitre d'exposition 26 de l'unité d'insolation 25 : l'insolation de la face verso 92 du panneau 90 a alors lieu. Cette étape est représentée en FIG 5G.

Une fois l'insolation de la face verso 92 du panneau 90 terminée, l'embase redescend et le mobile de déchargement vient récupérer le panneau 90 ainsi insolé sur ses deux faces 91 et 92.

Afin de simplifier l'exposé, cette cinématique n'a présenté l'insolation que d'un seul panneau 90, il va toutefois de soi que les opérations décrites peuvent s'enchaîner dans une logique de chaîne de production optimisée de telle manière que l'insolation de la face verso 92 d'un premier panneau 90 sur le deuxième poste 20 soit concomitante de l'insolation de la face recto 91 d'un deuxième panneau 90 sur la premier poste 10.

Les modes ou exemples de réalisation décrits dans le présent exposé sont donnés à titre illustratif et non limitatif, une personne du métier pouvant facilement, au vu de cet exposé, modifier ces modes ou exemples de réalisation, ou en envisager d'autres, tout en restant dans la portée de l'invention.

En particulier, l'exemple décrit dans le présent exposé comporte deux postes d'insolation mais il va de soi que la machine pourrait ne comporter qu'un seul poste d'insolation. Dans un tel cas, une fois l'insolation de la face recto 91 du panneau 90 terminée au sein de l'unique poste d'insolation 10, l'embase 12 redescend et le cadre 30 est déplacé en vis-à-vis de l'embase 12 pour saisir le panneau 90 à l'aide des ventouses 53, 54. Le panneau 90 fermement saisi par les lames 51, 52, le cadre 40 se déplace horizontalement à l'écart du poste d'insolation 10 jusqu'à une position dans laquelle le cadre 40 a suffisamment d'espace pour pouvoir être retourné. Une fois retourné, le cadre 40 est ramené, tête en bas, vers l'unique poste d'insolation 10. Une fois le cadre 40 en vis-à-vis de l'embase 12, le panneau 90 est libéré et déposé sur l'embase 12 : celle-ci peut alors remonter jusqu'à plaquer la table de travail 13 et le panneau 90 contre la vitre d'exposition 16 de l'unité d'insolation 15 : l'insolation de la face verso 92 du panneau 90 a alors lieu.

De plus, les différentes caractéristiques de ces modes ou exemples de réalisation peuvent être utilisées seules ou être combinées entre elles. Lorsqu'elles sont combinées, ces caractéristiques peuvent l'être comme décrit ci-dessus ou différemment, l'invention ne se limitant pas aux combinaisons spécifiques décrites dans le présent exposé. En particulier, sauf précision contraire, une caractéristique décrite en relation avec un mode ou exemple de réalisation peut être appliquée de manière analogue à un autre mode ou exemple de réalisation.

## Revendications

1. Machine d'insolation de panneaux comprenant :
- au moins un poste d'insolation (10) comportant une embase (11) configurée pour recevoir un panneau (90) à plat, et
- un retourneur de panneau (30), ayant une première face et une deuxième face,
**caractérisée en ce que** le retourneur de panneau comprend
- un dispositif de préhension (53, 54), configuré pour saisir un panneau (90),
- un dispositif de déplacement (33), configuré pour pouvoir amener le dispositif de préhension (53, 54) en vis-à-vis de l'embase (11, 21) dudit au moins un poste d'insolation (10, 20), et
- un dispositif de pivotement (73), configuré pour pivoter le dispositif de préhension (53, 54) et ainsi faire pivoter le panneau (90) autour d'un axe de pivotement (A) parallèle audit panneau (90), le retourneur (30) étant configuré de manière à pouvoir saisir le panneau (90) par l'une quelconque de ses faces et libérer le panneau (90) également par l'une quelconque de ses faces.

2. Machine d'insolation de panneaux selon la revendication 1, **caractérisée en ce qu'**elle comprend un premier poste d'insolation (10) et un deuxième poste d'insolation (20), chaque poste d'insolation (10, 20) comportant une embase (11, 21) configurée pour recevoir le panneau (90) à plat, et
**en ce que** le dispositif de déplacement (33) est configuré pour pouvoir amener le dispositif de préhension (53, 54) en vis-à-vis de l'embase (11, 21) de chaque poste d'insolation (10, 20),

3. Machine d'insolation de panneaux selon la revendication 1 ou 2, **caractérisée en ce que** l'embase (11) dudit au moins un poste d'insolation (10) est munie d'un élévateur (12) lui permettant de monter ou de descendre.

4. Machine d'insolation de panneaux selon la revendication 3, caractérisée en ce ledit au moins un poste d'insolation (10) comporte en outre une unité d'insolation (12) munie d'un dispositif d'insolation et configurée pour porter un cliché, l'unité d'insolation (12) du poste d'insolation (10) étant fixe.

5. Machine d'insolation de panneaux selon l'une quelconque des revendication 1 à 4, **caractérisée en ce que** le retourneur (30) comprend un support (70) et un cadre (40) sensiblement rectangulaire coopérant avec le support (70) par l'intermédiaire de deux tourillons (42a, 42b) disposés sur le cadre (40), ou sur le support (70), de manière coaxiale et de part et d'autre du cadre (40), définissant ainsi un axe de pivotement (A) du cadre (40) par rapport au support (70), ledit axe correspondant audit axe de pivotement (A) du panneau (90),
**en ce que** le cadre (40) comporte deux traverses longitudinales (50), de préférence parallèles à l'axe de pivotement (A), portant le dispositif de préhension (53, 54), et
**en ce que** le dispositif de pivotement (73), porté de préférence par le support (70), entraine au moins un desdits tourillons (42b) pour pivoter le cadre par rapport au support.

6. Machine d'insolation de panneaux selon la revendication 5, **caractérisée en ce que** le support (70) coopère avec au moins un rail (31, 32) de la machine d'insolation (1) le long duquel il est mobile et entraîné par le dispositif de déplacement (53), et **en ce que** ledit rail (31, 32) est horizontal, le déplacement du support (70) étant limité à un déplacement horizontal.

7. Machine d'insolation de panneaux selon la revendication 5 ou 6, **caractérisée en ce que** chaque traverse (50) comprend deux lames (51, 52) munies chacune d'un dispositif d'entraînement rotatif, de préférence un vérin rotatif (46), lui permettant de pivoter autour d'un axe (V) parallèle à ladite traverse (50), et **en ce que** chaque lame (51, 52) est munie d'une pluralité de ventouses (53, 54) commandées reliées à une pompe à vide et agissant comme dispositif de préhension.

8. Machine d'insolation de panneaux selon la revendication 7, **caractérisée en ce que** les lames (51, 52) d'une même traverse sont déportées par rapport à leurs axes de pivotement (V) de telle sorte qu'elles peuvent s'étendre côte-à-côte dans un même plan ou en vis-à-vis, les ventouses (53, 54) de l'une étant alors dirigées vers les ventouses (53, 54) de l'autre.

9. Machine d'insolation de panneaux selon la revendication 7 ou 8, caractérisée en ce au moins une ventouse (54) est munie d'un clapet automatique qui se ferme lorsqu'aucun objet n'est appliqué contre ladite ventouse.

10. Machine d'insolation de panneaux selon l'une quelconque des revendications 7 à 9, caractérisée en ce au moins une ventouse (53, 54) est munie d'un ressort (57) qui la repousse loin de la lame (51, 52) sur laquelle elle est montée.

11. Machine d'insolation de panneaux selon l'une quelconque des revendications 5 à 10, caractérisée en ce chaque traverse (50) est montée entre deux chariots opposés (44), chaque chariot (44) étant mobile et entrainé le long d'un montant (41a, 41c) du cadre (40).

12. Machine d'insolation de panneaux selon la revendication 11, **caractérisée en ce que** chaque chariot (44) coopère avec une barre de guidage (42) disposée le long dudit montant (41a, 41c) du cadre (40),
**en ce qu'**une vis d'Archimède est disposée le long d'au moins un desdits montants (41a, 41c), et
**en ce que** certains chariots (44) comportent un moteur (45) engrenant sur ladite vis d'Archimède (43) pour assurer leurs déplacements le long desdits montants (41a, 41c).

13. Machine d'insolation de panneaux selon l'une quelconque des revendications 5 à 12, **caractérisée en ce que** le dispositif de pivotement comprend un moteur (73), monté sur le support (70), qui entraîne, de préférence par l'intermédiaire d'un réducteur à renvoi d'angle (74), un des tourillons (42b) du cadre (40) pour le pivoter le cadre (40) dans une plage d'inclinaison d'au moins 180° d'amplitude.

14. Procédé d'insolation de panneaux utilisant une machine d'insolation (1) selon l'une quelconque des revendications précédentes.
